# EUROPEAN PATENT APPLICATION

(11) **EP 4 411 391 A1**
(43) Date of publication of application: **07.08.2024**
(21) Application number: 24152813.2
(22) Date of filing: 19.01.2024
(51) Int. Cl.: G01R 15/20

(54) **PROTECTIVE STRUCTURE TO IMPROVE RELIABILITY OF MAGNETIC FIELD DETECTION IN A NON-INVASIVE CURRENT SENSOR**

(30) Priority: 06.02.2023 CN 202310100326
(71) Applicant: Honeywell International Inc., Charlotte, NC 28202 (US)
(72) Inventor: YANG, Fan, Charlotte, 28202 (US); WANG, Jun, Charlotte, 28202 (US); HU, Yu, Charlotte, 28202 (US); AI, Lei, Charlotte, 28202 (US); CHEN, Wu, Charlotte, 28202 (US); SUN, Jun, Charlotte, 28202 (US)
(74) Representative: Haseltine Lake Kempner LLP

(57) **Abstract**

A non-invasive current sensor and a method for assembling the non-invasive current sensor are provided. An example non-invasive current sensor may include a first housing, the first housing including a magnetic core having a first end and a second end and a protective case. The magnetic core may be formed into a substantially complete perimeter having a center opening, and defining an air gap may between the first end and the second end of the magnetic core. The first housing may further include a protective case disposed in the air gap of the magnetic core. In addition, the non-invasive current sensor may include a second housing having a sensing element. The sensing element may be positioned such that in an instance in which the first housing is attached to the second housing, the protective case receives the sensing element.

## Description

### TECHNOLOGICAL FIELD

Embodiments of the present disclosure relate generally to non-invasive current sensors, and more particularly, to non-invasive current sensors utilizing a magnetic core concentrator and one or more sensing elements to determine properties of a magnetic field near a conductive wire.

### BACKGROUND

Applicant has identified many technical challenges and difficulties associated with measuring the properties of a magnetic field near a current-carrying conductive wire. Through applied effort, ingenuity, and innovation, Applicant has solved problems related to the reliability of magnetic field measurements in diverse environmental conditions by developing solutions embodied in the present disclosure, which are described in detail below.

### BRIEF SUMMARY

Various embodiments are directed to an example apparatus for measuring the magnetic field properties near a current-carrying conductive wire.

In accordance with some embodiments of the present disclosure, and example apparatus is provided. In some embodiments, the apparatus may comprise a first housing comprising a magnetic core having a first end and a second end, wherein the magnetic core may be formed into a substantially complete perimeter comprising a center opening, and wherein an air gap may be defined between the first end and the second end of the magnetic core. The first housing may further comprise a protective case, wherein the protective case may be disposed in the air gap of the magnetic core. In addition, the apparatus may comprise a second housing comprising a sensing element. The sensing element may be positioned such that in an instance in which the first housing is attached to the second housing, the protective case receives the sensing element.

In some embodiments, the protective case may define a partially enclosed space, wherein the protective case comprises a case opening, and wherein the protective case receives the sensing element through the case opening and into the partially enclosed space.

In some embodiments, the adhesive substance may be disposed in the partially enclosed space of the protective case.

In some embodiments, the adhesive substance may comprise a one component epoxy compound heat cure adhesive.

In some embodiments, the protective case may be removable.

In some embodiments, in an instance in which the first housing and the second housing are separated, the protective case may remain attached to the second housing.

In some embodiments, the protective case may comprise a synthetic polymer.

In some embodiments, the first housing and the second housing may be substantially similar in shape.

In some embodiments, the first housing and the second housing may be configured to attach forming a protective housing.

In some embodiments, the protective housing may form an interior cavity substantially isolated from an exterior environment without the protective housing.

In some embodiments, the apparatus may further comprise a first housing opening in the first housing and a second housing opening in the second housing, wherein in an instance in which the first housing and the second housing are attached to form the protective housing the first housing opening and the second housing opening are substantially aligned forming a housing opening, and wherein the housing opening provides a passageway through the protective housing.

In some embodiments, the housing opening may be substantially aligned with the center opening of the magnetic core.

In some embodiments, in an instance in which a conductive wire is passed through the housing opening, the conductive wire may simultaneously pass through the center opening of the magnetic core.

In some embodiments, in an instance in which a current passes through the conductive wire, a magnetic field may be concentrated in the magnetic core.

In some embodiments, the sensing element may convert a characteristic of the magnetic field concentrated within the magnetic core into a voltage.

In some embodiments, the sensing element may be one of a hall effect sensor, an anisotropic magneto-resistive (AMR) sensor, a tunneling magneto-resistive (TMR) sensor, and a giant magneto-resistive (GMR) sensor.

In some embodiments, the characteristic of the magnetic field may be at least one of a magnitude of the magnetic field and an angle of the magnetic field.

In some embodiments, the apparatus may further comprise a circuit board attached to the second housing, wherein the voltage is transmitted to the circuit board.

An example method for assembling an apparatus, the apparatus comprising a first housing and a second housing, the first housing comprising a magnetic core having a first end and a second end and a protective case, the second housing comprising a sensing element, wherein the magnetic core is formed into a substantially complete perimeter comprising a center opening, wherein an air gap is defined between the first end and the second end of the magnetic core, is further provided. In some embodiments, the method may comprise disposing the protective case in the air gap of the magnetic core, and attaching the first housing to the second housing such that the protective case receives the sensing element.

In some embodiments, attaching the first housing to the second housing may comprise injecting an adhesive substance inside the protective case such that the adhesive substance is configured to couple the sensing element and the protective case.

### BRIEF DESCRIPTION OF THE DRAWINGS

Reference will now be made to the accompanying drawings. The components illustrated in the figures may or may not be present in certain embodiments described herein. Some embodiments may include fewer (or more) components than those shown in the figures in accordance with an example embodiment of the present disclosure.
FIG. 1 illustrates an example magnetic core concentrator and associated example housing for an example non-invasive current sensor in accordance with an example embodiment of the present disclosure.
FIG. 2 illustrates an example protective case disposed in an air gap of an example magnetic core concentrator in accordance with an example embodiment of the present disclosure.
FIG. 3 illustrates an example adhesive substance disposed within the example protective case in accordance with an example embodiment of the present disclosure.
FIG. 4 illustrates an example sensing element and associated example housing for an example non-invasive current sensor in accordance with an example embodiment of the present disclosure.
FIG. 5 illustrates an example assembly of an example non-invasive current sensor in accordance with an example embodiment of the present disclosure.
FIG. 6 illustrates an assembled example non-invasive current sensor receiving a conductive wire in accordance with an example embodiment of the present disclosure.
FIG. 7A illustrates a disassembled example non-invasive current sensor in accordance with an example embodiment of the present disclosure.
FIG. 7B shows an additional view of a disassembled example non-invasive current sensor in accordance with an example embodiment of the present disclosure.
FIG. 8 depicts an example flowchart illustrating an example method for assembling a non-invasive current sensor in accordance with an example embodiment of the present disclosure.

### DETAILED DESCRIPTION

Example embodiments will be described more fully hereinafter with reference to the accompanying drawings, in which some, but not all embodiments of the inventions of the disclosure are shown. Indeed, embodiments of the disclosure may be embodied in many different forms and should not be construed as limited to the embodiments set forth herein; rather, these embodiments are provided so that this disclosure will satisfy applicable legal requirements. Like numbers refer to like elements throughout.

Various example embodiments address technical problems associated with measuring the electric current in a conductive wire in a non-invasive manner. As understood by those of skill in the field to which the present disclosure pertains, there are numerous example scenarios in which a user may need to measure the electric current in a conductive wire without accessing the conductive components.

For example, many electronic systems include conductive wiring connecting various components of the electronic system. In some embodiments, an electronic system and/or user of the electronic system may utilize the flow of current through the conductive wiring to determine the health and/or overall operation of the electronic system. Additionally, in some embodiments, the electronic system and/or user of the electronic system may benefit from monitoring various characteristics of the current flow through the connecting conductive wiring as part of the operation of the electronic system, for example the magnitude of the current flow. However, in some electronic systems, access to the current-carrying conductive components is undesirable and/or not readily available. Thus, a non-invasive method for measuring the current in a conductive wire may be utilized.

One example method for non-invasively measuring the current in a conductive wire is to leverage the principles of physics that dictate for a given current flow through a conductive wire, a proportional magnetic field is produced around the conductive wire. Thus, measuring the magnetic field proximate the conductive wire may provide insight into the current flow through the conductive wire. In general, non-invasive current sensing devices measuring the magnetic field proximate a conductive wire include a magnetic core ring or concentrator forming a ring around the conductive wire. In some embodiments, the magnetic core ring concentrates the magnetic field generated by the conducting wire in the magnetically permeable magnetic core ring. In addition, in some examples, the magnetic core ring may include a small air gap in the ring structure. In some embodiments, a Hall effect sensor or other sensing device may be placed within the air gap to measure the properties of the magnetic field concentrated in the magnetic core ring. The sensing device placed within the air gap of the magnetic core ring may produce a voltage proportional to a measured characteristic of the magnetic field, for example, the strength of the magnetic field. The produced voltage may be amplified and/or otherwise conditioned and transmitted to a processor or other connected device for further analysis and determination of the magnetic field characteristic and associated current.

In operation, sensing devices, such as a Hall effect sensor, utilized to measure the magnetic field proximate the conducting wire may be easily influenced by the surrounding environment. For example, changes in temperature and/or humidity may affect the accuracy of the sensing device. In some embodiments, the sensing devices are deployed in environments highly susceptible to changes in environment conditions, such as electric vehicles. Sensing devices disposed in and on an electric vehicle may be exposed to wide variances in temperature, humidity, pressure, dust, debris, water, and other external environment factors. The changes in the external environment may cause inaccuracies in the determined current properties based on the measured magnetic field. The inaccuracies of the determined current can be problematic for current sensors required to measure current properties with a high accuracy (e.g., current measurements within 5% of the actual current).

The various example embodiments described herein utilize various techniques to measure the magnetic field proximate a current-carrying conductive wire and determine properties related to the flow of current in the conductive wire. For example, in some embodiments, a non-invasive current sensor may include a protective case disposed within the air gap in the structure of the magnetic core ring. In such an embodiment, the sensing device utilized to measure the magnetic field may be positioned within the protective case. The protective case may provide protection to the sensing device from changes in the external environment, such as changes in the temperature, humidity, pressure, or other physical characteristics of the surrounding environment. Further, in some embodiments, the protective case may be filled with an adhesive substance, such as glue. The sensing device may be disposed in the adhesive substance, providing further protection from changes in the external environment.

Additionally, in some embodiments, the magnetic core ring, protective case filled with the adhesive substance, and the sensing device may be encased in a protective housing. In some embodiments, the protective housing may comprise two housings: (1) a magnetic core housing containing the magnetic core ring and protective case disposed within the air gap of the magnetic core ring and filled with an adhesive substance; and (2) a sensor housing containing the sensing device. In some embodiments, the sensing device and the protective case may be positioned such that in an instance in which the magnetic core housing and the sensor housing are attached, the protective case receives the sensing device into the adhesive substance. In some embodiments, the magnetic core housing and the sensor housing may each contain an opening in the housing that substantially align, such that, in an instance in which the two housings are attached a passageway is formed through the attached housings passing from one side of the housing to the other, through the center opening of the magnetic core ring.

In some embodiments, the current-carrying conductive wire may pass through the passageway formed by the attached housings, such that the conductive wire passes through the center opening of the magnetic core ring. In such an embodiment, the magnetic field created by the current passing through the conductive wire may be concentrated in the magnetic core ring. Concentrating the magnetic field in the magnetic core ring may enable higher resolution measurements by the sensing device of the magnetic field proximate the conductive wire. The attached housings may substantially seal the internal components of the current sensor, providing additional protection to the sensing device, and other components internal to the attached housings, from changes in the external environment.

Additionally, in some embodiments, in an instance in which the magnetic core housing and the sensor housing are separated after being attached, the adhesive substance may cause the protective case to be removed from the air gap in the structure of the magnetic core ring. Removing the protective case from the air gap when the housings are separated allows for disassembly and re-assembly of the protective housing and the current sensor. Disassembly and re-assembly may enable repair, maintenance, and/or replacement of components contained within the protective housing without destruction of the non-invasive current sensor.

As a result of the herein described example embodiments and in some examples, the accuracy and reliability of non-invasive current sensors may be greatly improved. In addition, the ability to disassemble and re-assemble non-invasive current sensors once in operation may improve the usability and longevity of non-invasive current sensors in accordance with the herein described example embodiments.

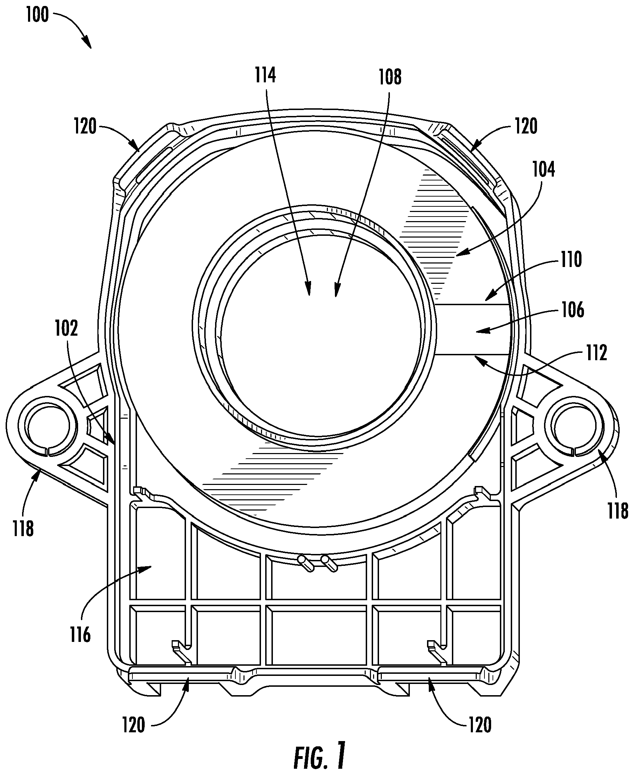

Referring now to FIG. 1, a perspective view of an example magnetic core portion 100 of an example non-invasive current sensor is provided. As depicted in FIG. 1, the example magnetic core portion 100 includes a magnetic core housing 102 (e.g., first housing). The example magnetic core housing 102 defining a partially-enclosed internal magnetic core housing cavity 116 in which components of the non-invasive current sensor may be disposed. The example magnetic core housing 102 further defines a circular opening, magnetic core housing opening 108, passing through the magnetic core housing 102. FIG. 1 further depicts a magnetic core ring 104 disposed within the internal magnetic core housing cavity 116 and forming a ring shape substantially encircling the magnetic core housing opening 108. The ring shape of the example magnetic core ring 104 defines a center opening 114, substantially co-axial with the magnetic core housing opening 108. As depicted in FIG. 1, the magnetic core ring 104 further defines an air gap 106 in the structure of the magnetic core ring 104 between the first end 110 and second end 112 of the magnetic core ring 104.

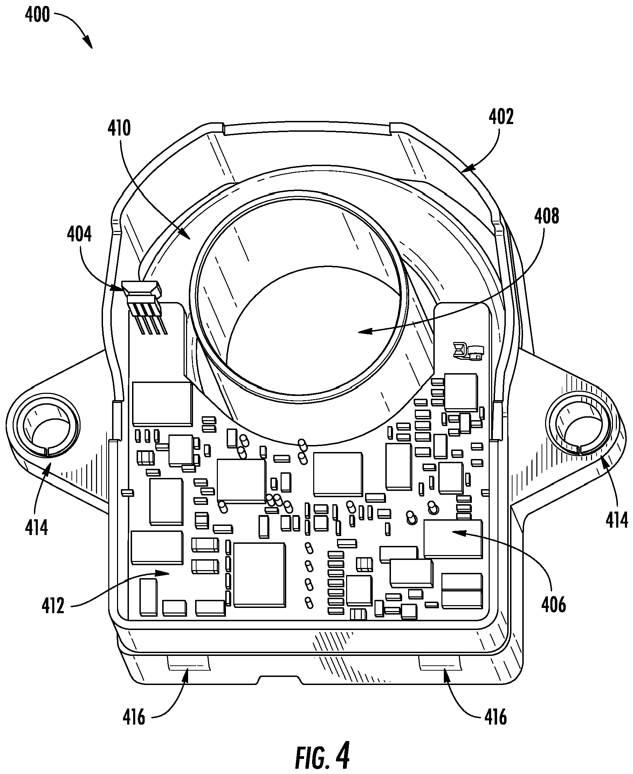

As depicted in FIG. 1, the example magnetic core portion 100 of the example non-invasive current sensor includes a magnetic core housing 102. The magnetic core housing 102 may comprise any structure, edifice, or other apparatus defining an internal cavity, such as magnetic core housing cavity 116, in which components of the non-invasive current sensor may be disposed. In some embodiments, the magnetic core housing 102 may comprise a polymer, such as plastic, wood, and/or any other material such that a magnetic field may pass through unobstructed. The magnetic core housing 102 may further include elements to facilitate attachment of the magnetic core housing 102 to a second housing (e.g., sensor housing 402 as depicted in relation to FIG. 4). As depicted in FIG. 1, the example magnetic core housing 102 includes flanges 118 and latches 120 to facilitate such an attachment. As further depicted, the surface intended to interface with the second housing is open, allowing components in the second housing to interact with components in the first housing. In some embodiments, the surface intended to interface with the second housing may be partially open, providing openings in which components from the second housing may pass through to interact with components of the first housing.

As further depicted in FIG. 1, the example magnetic core housing 102 defines a magnetic core housing opening 108. The magnetic core housing opening 108 may be any hole, opening, or other passageway that enables passage of an object (e.g., a conductive wire) through the magnetic core housing 102. Although depicted as circular in FIG. 1, the magnetic core housing opening 108 may be any size or shape facilitating passage through the magnetic core housing 102 structure.

As further depicted in FIG. 1, the example magnetic core housing 102 includes a magnetic core ring 104. The magnetic core ring 104 may be any material that may be used to direct or intensify the magnetic field toward a sensing device (e.g., sensing element 404 as described in relation to FIG. 4). In some embodiments, the magnetic core ring 104 may comprise a ferrous material, such as steel, or other magnetic material or combination of magnetic materials. In some embodiments, the magnetic core ring 104 may comprise a plurality of structures and/or materials.

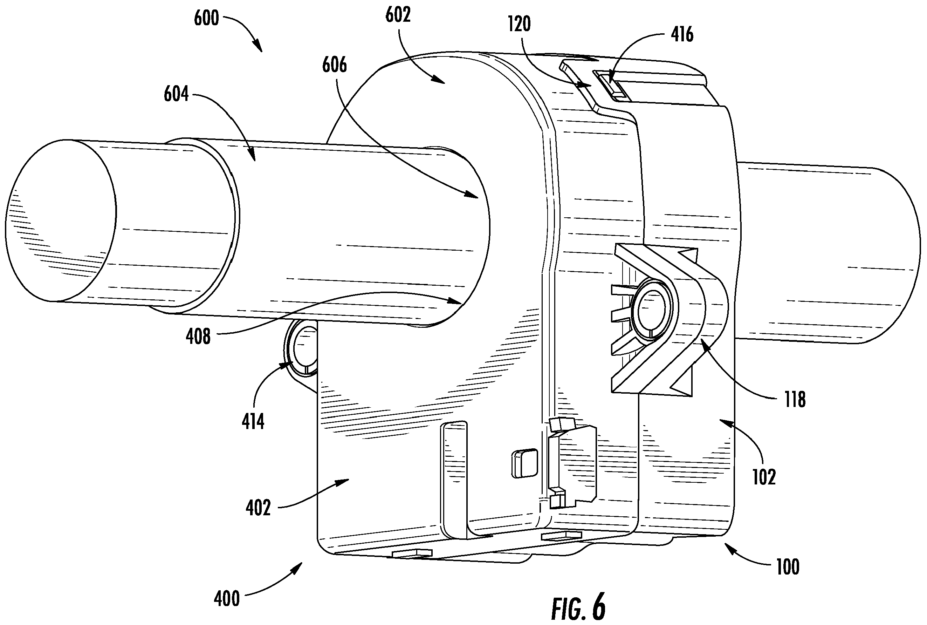

As further depicted in FIG. 1, the example magnetic core ring 104 comprises a magnetic core material having a first end 110 and a second end 112. The example magnetic core ring 104 is formed such that the magnetic core material is formed into a loop or ring forming an outer perimeter with the first end 110 in close proximity to the second end 112. The shape of the magnetic core ring 104 further defines an opening (e.g., center opening 114) through which a conductive wire (e.g., conductive wire 604 as further described in relation to FIG. 6) may pass through the magnetic core ring 104. While depicted as a ring shape in FIG. 1, the magnetic core ring 104 may be any shape forming a substantially enclosed loop, such that a current-carrying conductive wire may pass through the center opening 114 in the defined shape. For example, in some embodiments, the magnetic core ring 104 may be C-shaped, oval shaped, square-shaped, U-shaped, or any other shape in which an opening is defined and the first end 110 and the second end 112 form a gap in the magnetic core material.

As further depicted in FIG. 1, the example magnetic core ring 104 is shaped to define an air gap 106 between the first end 110 and the second end 112 of the magnetic core material. Forming an air gap 106 in the magnetic core ring 104 enables insertion of a sensing device (e.g., sensing element 404) into the air gap 106 to measure characteristics of the magnetic field. The air gap 106 may vary in size based on the magnetic core material, the shape and size of the magnetic core ring 104, the size of the conductive wire, the magnitude and frequency of the current passing through the current-carrying conductive wire, the size and type of the sensing device, the material comprising the magnetic core housing 102, and other factors related to the production and propagation of the magnetic field. As further described in relation to FIG. 4, a sensing device (e.g., sensing element 404) may be placed within the air gap 106 to measure the physical properties of the magnetic field concentrated in the magnetic core ring 104.

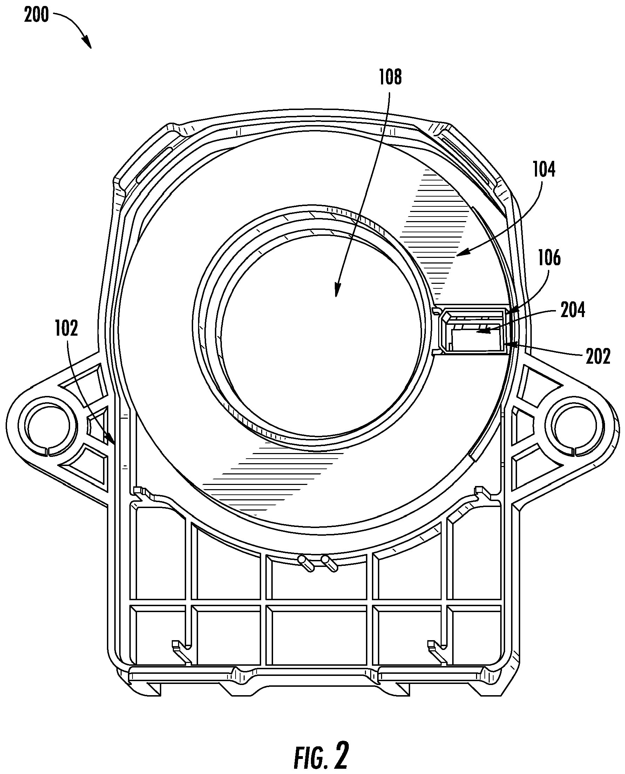

Referring now to FIG. 2, a perspective view of an example magnetic core portion 200 of an example non-invasive current sensor is provided. As depicted in FIG. 2, the example magnetic core portion 200 includes a protective case 202 defining a protective case cavity 204 disposed within the air gap 106 of the magnetic core ring 104.

As depicted in FIG. 2, the example magnetic core portion 200 includes a protective case 202 disposed within the air gap 106 of the example magnetic core ring 104. The protective case 202 may comprise any polymer, such as plastic, rubber, silicone, and/or other synthetic or semi-synthetic polymer material allowing a magnetic field to pass through unobstructed. In some embodiments, the protective case 202 may form a partially enclosed space wherein at least one surface of the protective case 202 contains one or more openings (e.g., case opening). In some embodiments, the protective case 202 may be disposed within the air gap 106 and configured to receive a sensing device (e.g., sensing element 404 as described in relation to FIG. 4) through the one or more openings in the protective case 202.

In some embodiments, the protective case 202 may be attached to a sensing device and aligned to fit in the air gap 106 of the magnetic core ring 104. The protective case 202 may provide protection from changes in the external environment, such as changes in humidity, temperature, pressure, etc. In some embodiments, the sensing device disposed within the protective case 202 may be susceptible to changes in the external environment leading to inaccurate or unreliable sensor measurements. The protective case 202 may reduce and/or eliminate the effect changes in the external environment have on sensing device readings.

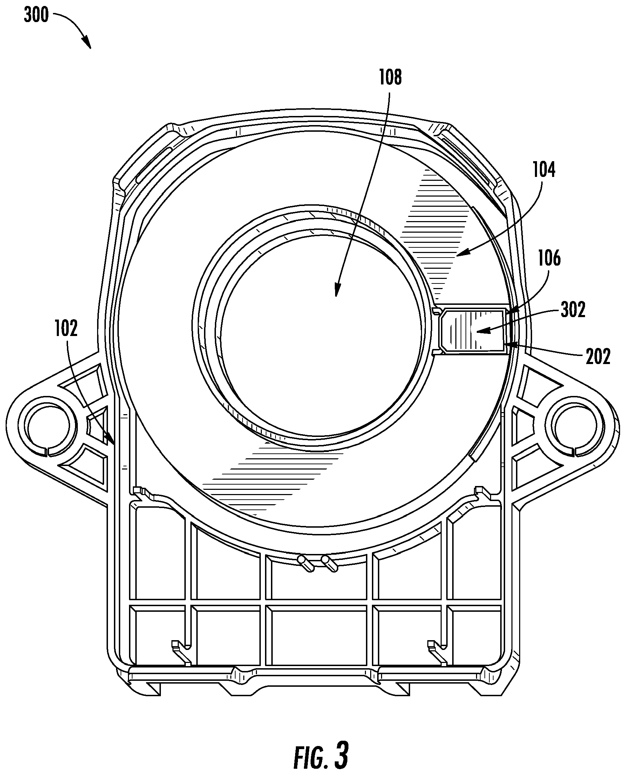

Referring now to FIG. 3, a perspective view of an example magnetic core portion 300 of an example non-invasive current sensor is provided. As depicted in FIG. 3, the example protective case 202 is disposed within the air gap 106 of the example magnetic core ring 104. As further depicted in FIG. 3, the example protective case 202 is filled with an adhesive substance 302.

As depicted in FIG. 3, the example protective case 202 of the example magnetic core portion 300 is filled with an adhesive substance 302. The adhesive substance 302 may be any substance, material, compound, or other similar matter that attaches the protective case 202 to the sensing device (e.g., sensing element 404 as described in relation to FIG. 4) and/or protects the sensing device from changes in the surrounding environment (e.g., temperature, humidity, pressure, etc.). For example, the adhesive substance 302 may comprise polymer dispersion adhesives (e.g., polyvinyl acetate based adhesives), solvent-based adhesives (e.g., polymer based solvents), heat cure adhesives, or any other adhesive material configured to form a bond between the protective case 202 and the sensing device. In one specific example embodiment, the adhesive substance 302 may comprise a one component epoxy compound heat cure adhesive. Such an adhesive substance 302 may comprise a premixed epoxy resin that may react and polymerize when heated to a minimum curing temperature, for example 120 degrees Celsius.

In some embodiments, the adhesive substance 302 may be injected into the protective case 202 previous to assembling the protective housing (e.g., protective housing 602). In such an instance, the adhesive substance 302 may attach the protective case 202 to the sensing device at the time the protective housing is assembled. In some embodiments, the adhesive substance 302 may be utilized to attach the protective case 202 to the sensing device previous to assembling the protective housing. In such an instance, the sensing device and the attached protective case 202 may be inserted into the air gap 106 of the magnetic core ring 104 at the time the protective housing is assembled.

Referring now to FIG. 4, a perspective view of an example sensor portion 400 of an example non-invasive current sensor is provided. As depicted in FIG. 4, the example sensor portion 400 includes a sensor housing 402 (e.g., second housing). The example sensor housing 402 defining a partially-enclosed internal sensor housing cavity 412 in which components of the non-invasive current sensor may be disposed. The example sensor housing 402 further defines a circular opening, sensor housing opening 408, passing through the sensor housing 402. The example sensor housing 402 further includes a sensing element 404 disposed within the sensor housing 402. FIG. 4 further depicts additional elements disposed in the sensor housing 402, for example, a circuit board 406 and a fluxgate 410. The example sensing element 404 in the example sensor portion 400 of the non-invasive current sensor protrudes above the surface of the additional elements disposed in the sensor housing 402. As depicted in FIG. 4, the sensor housing 402 further includes structures to facilitate attachment to a housing, for example, magnetic core housing 102. These structures include flanges 414 and latching nubs 416.

As depicted in FIG. 4, the example sensor portion 400 of the example non-invasive current sensor includes a sensor housing 402. The sensor housing 402 may comprise any structure, edifice, or other apparatus defining an internal cavity, such as sensor housing cavity 412, in which components of the non-invasive current sensor may be disposed. In some embodiments, the sensor housing 402 may comprise a polymer, such as plastic, wood, and/or any other material such that a magnetic field may pass through unobstructed. The sensor housing 402 may further include elements to facilitate attachment of the sensor housing 402 to another housing (e.g., magnetic core housing 102 as described in relation to FIG. 1). For example, as depicted in FIG. 4, the example sensor housing 402 includes flanges 414 and latching nubs 416 to facilitate such an attachment. As further depicted in FIG. 4, the surface intended to interface with another housing is open, allowing components in the attaching housing to interact with components in the sensor housing 402. In some embodiments, the surface intended to interface with another housing may be partially open, providing openings in which components from the interfacing housing may pass through to interact with components of the sensor housing 402.

As depicted in FIG. 4, the size and shape of the example sensor housing 402 may be substantially equivalent to the size and shape of the corresponding attaching housing (e.g., magnetic core housing 102). In an instance in which the size and shape of the sensor housing 402 and the attaching housing are substantially equivalent, the attached housings may form a protective housing (e.g., protective housing 602 as further described in relation to FIG. 6) providing protection to the internal components of the non-invasive current sensor.

As further depicted in FIG. 4, the example sensor housing 402 defines a sensor housing opening 408. The sensor housing opening 408 may be any hole, opening, or other passageway that enables passage of an object (e.g., a conductive wire) through the sensor housing 402. Although depicted as circular in FIG. 4, the sensor housing opening 408 may be any size or shape facilitating passage through the sensor housing 402 structure.

As further depicted in FIG. 4, the example sensor housing 402 includes a sensing element 404. The sensing element 404 may be any sensing device configured to measure one or more magnetic field properties. In some embodiments, the sensing element 404 may output a voltage corresponding to the measure physical property of the magnetic field.

For example, a sensing element 404 may comprise a Hall effect sensor. A Hall effect sensor may detect the presence and magnitude of a magnetic field. In general, a Hall effect sensor may comprise a small plate having a potential difference across two sides of the plate, positioned in the presence of a magnetic field. The magnetic field may cause electrons to move to one side of the sensor plate and protons to move to the other side, thus creating a potential difference across the plate. The potential difference may be proportional to the magnitude of the magnetic field. In some embodiments, the voltage output of the Hall effect sensor may be conditioned and amplified before further analysis is performed.

Another example sensing element 404 may comprise an anisotropic magneto-resistive (AMR) sensor. An AMR sensor may measure the angle and/or presence of a magnetic field in relation to the sensor. The angle and/or presence of the magnetic field may provide information related to the current flow of a nearby current-carrying conductive wire.

Another example sensing element 404 may comprise a tunneling magneto-resistive (TMR) sensor. A TMR sensor may measure the angle and/or presence of a magnetic field in relation to the sensor. The angle and/or presence of the magnetic field may provide information related to the current flow of a nearby current-carrying conductive wire.

Another example sensing element 404 may comprise a giant magneto-resistive (GMR) sensor. A GMR sensor may similarly measure the angle and/or presence of a magnetic field in relation to the sensor. The angle and/or presence of the magnetic field may provide information related to the current flow of a nearby current-carrying conductive wire.

Further example sensing elements 404 may comprise a reed switch sensor, a search coil magnetometer, a semiconductor magneto-resistive (SMR) sensor, or other similar sensor used to measure one or more properties of a magnetic field.

In some embodiments, the sensing element 404 may be positioned in the air gap 106 of the magnetic core ring 104 to determine properties related to the flow of electricity through a current-carrying conductive wire (e.g., conductive wire 604 described in relation to FIG. 6) passing through the center opening 114 of the magnetic core ring 104. In such an embodiment, the current-carrying conductive wire may generate a magnetic field around the conductive wire. The magnetic core ring 104 may concentrate the generated magnetic field within the magnetic core ring 104, including across the air gap 106. In some embodiments, the sensing element 404 may be positioned within the air gap 106 to determine the magnitude, angle, presence, or other property related to the generated magnetic field. The sensing element 404 may further generate a voltage proportional to the measured magnetic field property.

In some embodiments, the output voltage generated by the sensing element 404 may be susceptible to variance based on the properties of the environment in which the sensing element 404 is confined. In some embodiments, variance in the output voltage (and thus the measured current) may be problematic, for example in applications requiring high accuracy current measurements (e.g., current measurements within 5% of the actual current). Properties of the environment causing variance in the current measurement may include temperature, humidity, pressure, and other similar properties.

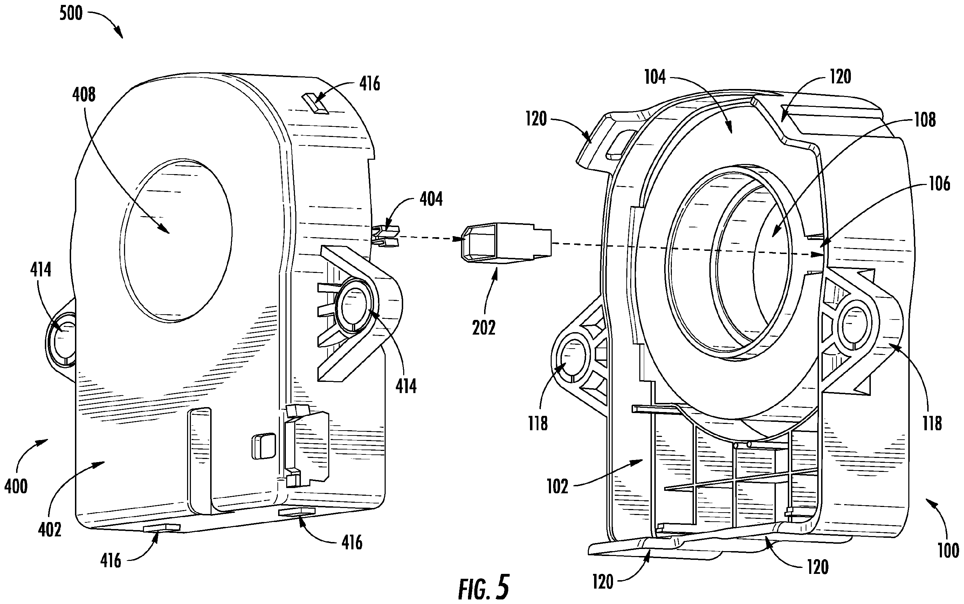

As depicted in FIG. 4, the sensing element 404 may protrude above the surface of the other components contained in the sensor housing 402. In some embodiments, a sensing element 404 protruding above the other components contained in the sensor housing 402 may enable the sensing element 404 to be positioned within the air gap 106 and within the adhesive substance 302 contained in the protective case 202 (as further depicted in relation to FIG. 5).

As further depicted in FIG. 4, the sensor housing 402 may include additional components utilized in the operation of a non-invasive current sensor, for example, a circuit board 406 and a fluxgate 410. In some embodiments, the sensing element 404 may be electrically connected to a circuit board 406, for example a printed circuit board. The circuit board may include components for conditioning the output voltage from the sensing element 404, such as amplifiers, low-pass filters, offset cancellation components, and other electrical components. The circuit board 406 may further include processors and/or transmitting devices, configured to analyze the output of the sensing element 404 and/or transmit the information related to the output of the sensing element 404 to other connected devices. As further depicted in FIG. 4, the example sensor housing 402 includes a fluxgate 410. A fluxgate 410 or similar component may be utilized to further enhance the accuracy of the non-invasive current sensor.

Referring now to FIG. 5, an exploded view of an example non-invasive current sensor 500 is provided. As depicted in FIG. 5, the example non-invasive current sensor 500 includes a magnetic core portion 100 and a sensor portion 400. The example non-invasive current sensor 500 further includes a protective case 202 positioned to fit in the air gap 106 of the magnetic core ring 104 and receive the sensing element 404 disposed within the sensor housing 402. The magnetic core housing 102 further includes latches 120 positioned to attach to the latching nubs 416 of the sensor housing 402, and flanges 118 configured to align with the flanges 414 of the sensor housing 402, to securely attach the magnetic core portion 100 and the sensor portion 400. As further depicted in FIG. 5, the magnetic core housing 102 contains a magnetic core housing opening 108 defining a passage through the magnetic core housing 102 within the inner circumference of the magnetic core ring 104. The sensor housing 402 includes a sensor housing opening 408 similarly defining a passage through the sensor housing 402. As depicted in FIG. 5, the magnetic core housing opening 108 and the sensor housing opening 408 substantially align to define a passage through the assembled non-invasive current sensor 500.

As depicted in FIG. 5, in some embodiments, one face of the sensor housing 402 is open, exposing the elements contained within the sensor housing 402. As further depicted in FIG. 5, one face of the magnetic core housing 102 is open, exposing the elements contained in the magnetic core housing 102. The sensor portion 400 and the magnetic core portion 100 are aligned such that the open face of the sensor housing 402 abuts the open face of the magnetic core housing 102 when the magnetic core portion 100 is attached to the sensor portion 400. Aligning the open faces enables the sensing element 404 of the sensor housing 402 to fit within the protective case 202 placed in the air gap 106 of the magnetic core ring 104 of the magnetic core housing 102.

In some embodiments, the protective case 202 may be positioned within the air gap 106 of the magnetic core ring 104 prior to attaching the sensor housing 402. In an instance in which the protective case 202 is placed in the air gap 106 prior to attaching the magnetic core portion 100 and the sensor portion 400, there may be a margin for error in which the sensing element 404 may be misaligned without damaging the sensing element 404. This may occur because the protective case 202 may be bigger than the sensing element 404. In contrast, in an instance in which the protective case 202 is placed on the sensing element 404 prior to attaching the magnetic core portion 100 and the sensor portion 400, the margin for error in alignment may be comparatively smaller because the protective case 202 may substantially fill the air gap 106. In such an instance, a slight misalignment may deform and/or damage the sensing element 404.

Referring now to FIG. 6, an example assembled non-invasive current sensor 600 is shown. As depicted in FIG. 6, the example non-invasive current sensor 600 includes a magnetic core portion 100 attached to the sensor portion 400 forming a protective housing 602 for all internal components of the non-invasive current sensor 600. As shown in FIG. 6, the latches 120 of the magnetic core housing 102 have engaged the latching nubs 416 of the sensor housing 402 attaching the magnetic core portion 100 of the non-invasive current sensor 600 to the sensor portion 400 of the non-invasive current sensor 600. FIG. 6, further depicts the flanges 118 of the magnetic core portion 100 aligned with the flanges 414 of the sensor portion 400. Further, a conductive wire 604 is depicted passing through the protective housing opening 606 formed by aligning the sensor housing opening 408 with the magnetic core housing opening 108.

As depicted in FIG. 6, the example non-invasive current sensor 600 includes a protective housing 602. The protective housing 602 is formed by securely attaching the magnetic core portion 100 of the non-invasive current sensor with the sensor portion 400 of the non-invasive current sensor. The latches 120 on the magnetic core portion 100 engage with the latching nubs 416 on the sensor portion 400 to securely attach the magnetic core portion 100 to the sensor portion 400. In addition, the flanges 118 of the magnetic core portion 100 align with the flanges 414 of the sensor portion 400. In some embodiments, a screw and nut, or other attaching mechanism, may be utilized to further secure the magnetic core portion 100 to the sensor portion 400.

Comprising the magnetic core housing 102 and the sensor housing 402, the protective housing 602 may comprise a polymer, such as plastic, a wood, and/or any other material such that a magnetic field may pass through unobstructed. The magnetic core housing 102 may provide initial protection to the internal components of the non-invasive current sensor from dirt, dust, build-up, water, and other substances likely to be encountered in the operating environment. In some embodiments, the protective housing 602 substantially seals the interior cavities (e.g., magnetic core housing cavity 116, sensor housing cavity 412) from infiltration of exterior substances or objects from the exterior environment proximate the protective housing 602.

As further depicted in FIG. 6, a conductive wire 604 may pass through the protective housing opening 606 defined by aligning the sensor housing opening 408 with the magnetic core housing opening 108 (as shown in FIG. 5). The protective housing opening 606 may be any passage that passes through the protective housing 602 and enables passage of a current-carrying wire (e.g., conductive wire 604) through the protective housing 602 and within the inner perimeter of the magnetic core ring 104 (as shown in FIG. 1 - FIG. 3 and FIG. 5). In some embodiments, the protective housing opening 606 may substantially seal the protective housing 602 isolating the interior cavities (e.g., magnetic core housing cavity 116, sensor housing cavity 412) from infiltration of exterior substances or objects from within the protective housing opening 606.

As depicted in relation to FIG. 1 - FIG. 3 and FIG. 5, the magnetic core housing opening 108 passes through the magnetic core housing 102 within the inner circumference of the magnetic core ring 104. As such, the conductive wire 604 passing through the protective housing opening 606 may pass through the inner circumference of the magnetic core ring 104. In an instance in which the conductive wire 604 is carrying a current, a magnetic field may be generated proximate the conductive wire 604. In some embodiments, the magnetic field may be concentrated and directed toward the sensing element 404 (as shown in FIG. 4 and FIG. 5) by the magnetic core ring 104. The sensing element 404 placed within the air gap 106 (as shown in FIG. 1 - FIG. 3 and FIG. 5) may detect the magnetic field and determine properties of the current carried by the conductive wire 604.

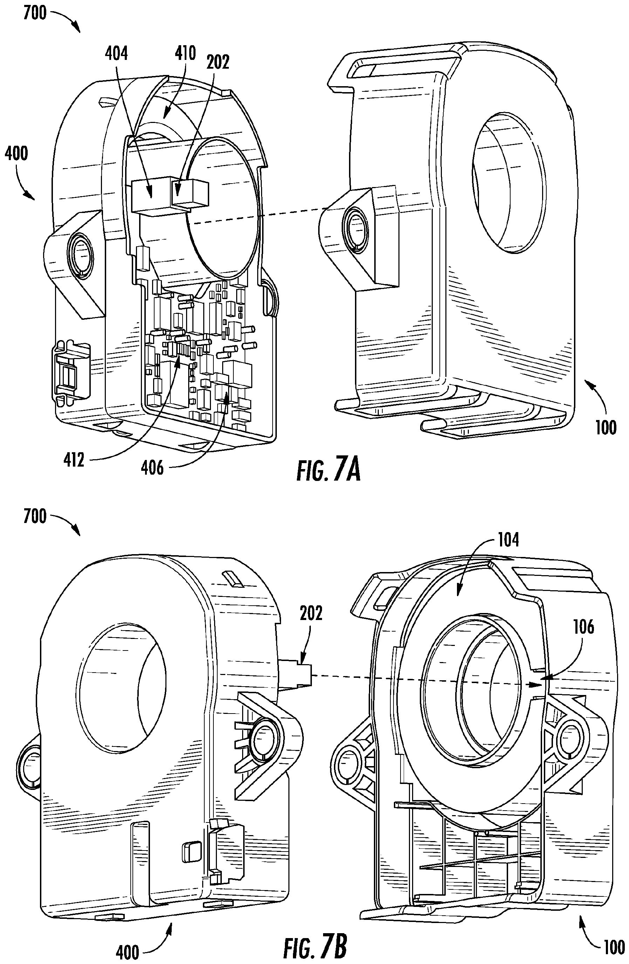

Referring now to FIG. 7a and FIG. 7b, two perspectives of a disassembled example non-invasive current sensor 700 are shown. As depicted in the perspective of FIG. 7a, a protective case 202 is attached to the sensing element 404 disposed within the sensor housing cavity 412 of the sensor portion 400 of the non-invasive current sensor 700. As depicted in the perspective of FIG. 7b, the protective case 202 has been removed from the air gap 106 of the magnetic core ring 104 disposed within the magnetic core housing cavity 116 of the magnetic core portion 100 of the non-invasive current sensor 700.

In some embodiments, an adhesive substance 302 (as described in relation to FIG. 3) may fill the protective case 202 before assembly of a non-invasive current sensor. In such an embodiment, the sensing element 404 may be received by the protective case 202 filled with the adhesive substance 302 during assembly. In some embodiments, an operation may be performed, such as baking, to cure the adhesive substance 302. In such an instance, the protective case 202 may become permanently attached to the sensing element 404. The adhesive substance 302 may provide protection from external environmental changes that may adversely affect the performance of the sensing element 404. In an instance in which the non-invasive current sensor 700 is disassembled, the protective case 202 may remain attached to the sensing element 404 as shown in FIG. 7a and FIG. 7b. Thus, the non-invasive current sensor 700 may be repeatedly assembled and disassembled without damage to the operating components. Disassembly of the non-invasive current sensor 700 may enable replacement or repair of internal components, such as components on the circuit board 406, the fluxgate 410, the magnetic core ring 104, or other internal components. Disassembly of the non-invasive current sensor 700 may further replacement of the sensing element 404 and/or the protective case 202.

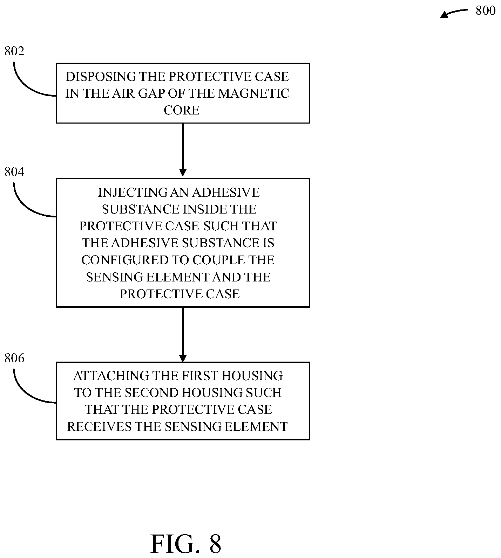

Referring now to FIG. 8, an example flow diagram illustrating an example method 800 for assembling a non-invasive current sensor (e.g., non-invasive current sensor 500, non-invasive current sensor 600, non-invasive current sensor 700) is provided.

At block 802, the example method 800 includes disposing the protective case (e.g., protective case 202) in the air gap (e.g., air gap 106) of the magnetic core (e.g., magnetic core ring 104). In some embodiments, the protective case may be placed in the air gap prior to attaching the first housing and the second housing of the non-invasive current sensor. The protective case may be attached within the air gap by an adhesive or other attaching mechanism such that the attaching mechanism may detach in an instance in which the non-invasive current sensor is disassembled, allowing the protective case to remain attached to the sensing element after disassembly.

At block 804, the example method 800 includes injecting an adhesive substance (e.g., adhesive substance 302) inside the protective case such that the adhesive substance is configured to couple the sensing element (e.g., sensing element 404) and the protective case. In some embodiments, the adhesive substance may be injected or otherwise placed inside of the protective case prior to attaching the first housing and the second housing of the non-invasive current sensor. The adhesive substance may sufficiently fill the protective case such that in an instance in which the sensing element is placed into the protective case and adhesive substance, the sensing structures of the sensing element are substantially covered. As described in relation to FIG. 3, the adhesive substance may provide protection from changes in the external environment that may affect the reliability of the sensing element, such as changes to humidity, temperature, pressure, etc.

At block 806, the example method 800 includes attaching the first housing (e.g., magnetic core housing 102) to the second housing (e.g., sensor housing 402) such that the protective case receives the sensing element. In some embodiments, the sensing element attached to the second housing may be received into the protective case and adhesive substance in an instance in which the first housing and the second housing are attached. Placing the sensing element in the adhesive and protective case during the assembly process may prevent the sensing element from being bent or damaged during the installation. In some embodiments, attaching the first housing to the second housing may further include curing the adhesive substance. The curing of the adhesive substance may be facilitated by heat, drying, immobilization, or any other procedure required to cure the adhesive substance.

Although the example flow diagram of FIG. 8 depicts the protective case placed in the air gap of the magnetic core and filled with an adhesive substance prior to attaching the first housing to the second housing, in some embodiments, the adhesive substance may be injected inside the protective case and the protective case may be placed directly on the sensing element previous to attaching the first housing and the second housing. Once the protective case is placed on the sensing element, the adhesive substance may undergo a curing process to cure the adhesive substance. In some embodiments, attaching the protective case to the sensing element and curing the adhesive substance prior to attaching the first housing to the second housing may reduce curing times and speed up the overall assembly process. In such an instance, the sensing element and attached protective case may be received into the air gap of the magnetic core in an instance in which the first housing is attached to the second housing.

Many modifications and other embodiments of the inventions set forth herein will come to mind to one skilled in the art to which these inventions pertain having the benefit of teachings presented in the foregoing descriptions and the associated drawings. Although the figures only show certain components of the apparatus and systems described herein, it is understood that various other components may be used in conjunction with the system. Therefore, it is to be understood that the inventions are not to be limited to the specific embodiments disclosed and that modifications and other embodiments are intended to be included within the scope of the appended claims. Moreover, the steps in the method described above may not necessarily occur in the order depicted in the accompanying diagrams, and in some cases one or more of the steps depicted may occur substantially simultaneously, or additional steps may be involved. Although specific terms are employed herein, they are used in a generic and descriptive sense only and not for purposes of limitation.

While various embodiments in accordance with the principles disclosed herein have been shown and described above, modifications thereof may be made by one skilled in the art without departing from the spirit and the teachings of the disclosure. The embodiments described herein are representative only and are not intended to be limiting. Many variations, combinations, and modifications are possible and are within the scope of the disclosure. The disclosed embodiments relate primarily to a non-invasive current sensor but the principles may apply to any sensing element disposed within a sensing device susceptible to changes in an external environment. Alternative embodiments that result from combining, integrating, and/or omitting features of the embodiment(s) are also within the scope of the disclosure. Accordingly, the scope of protection is not limited by the description set out above.

Additionally, the section headings used herein are provided for consistency with the suggestions under 37 C.F.R. 1.77 or to otherwise provide organizational cues. These headings shall not limit or characterize the invention(s) set out in any claims that may issue from this disclosure.

Use of broader terms such as "comprises," "includes," and "having" should be understood to provide support for narrower terms such as "consisting of," "consisting essentially of," and "comprised substantially of' Use of the terms "optionally," "may," "might," "possibly," and the like with respect to any element of an embodiment means that the element is not required, or alternatively, the element is required, both alternatives being within the scope of the embodiment(s). Also, references to examples are merely provided for illustrative purposes, and are not intended to be exclusive.

## Claims

1. An apparatus comprising:
a first housing comprising:
a magnetic core having a first end and a second end,
wherein the magnetic core is formed into a substantially complete perimeter comprising a center opening, and
wherein an air gap is defined between the first end and the second end of the magnetic core;
a protective case,
wherein the protective case is disposed in the air gap of the magnetic core; and
a second housing comprising:
a sensing element;
wherein the sensing element is positioned such that in an instance in which the first housing is attached to the second housing, the protective case receives the sensing element.

2. The apparatus of Claim 1, wherein the protective case defines a partially enclosed space, wherein the protective case comprises a case opening, and wherein the protective case receives the sensing element through the case opening and into the partially enclosed space.

3. The apparatus of Claim 2, wherein an adhesive substance is disposed in the partially enclosed space of the protective case.

4. The apparatus of Claim 1, wherein the protective case is removable.

5. The apparatus of Claim 4, wherein in an instance in which the first housing and the second housing are separated, the protective case remains attached to the second housing.

6. The apparatus of Claim 1, wherein the first housing and the second housing are substantially similar in shape,
wherein the first housing and the second housing are configured to attach forming a protective housing, and
wherein the protective housing forms an interior cavity substantially isolated from an exterior environment without the protective housing.

7. The apparatus of Claim 6, further comprising:
a first housing opening in the first housing; and
a second housing opening in the second housing;
wherein in an instance in which the first housing and the second housing are attached to form the protective housing the first housing opening and the second housing opening are substantially aligned forming a housing opening, and
wherein the housing opening provides a passageway through the protective housing.

8. The apparatus of Claim 7, wherein the housing opening is substantially aligned with the center opening of the magnetic core.

9. The apparatus of Claim 8, wherein in an instance in which a conductive wire is passed through the housing opening, the conductive wire simultaneously passes through the center opening of the magnetic core.

10. The apparatus of Claim 9, wherein in an instance in which a current passes through the conductive wire, a magnetic field is concentrated in the magnetic core.

11. The apparatus of Claim 10, wherein the sensing element converts a characteristic of the magnetic field concentrated within the magnetic core into a voltage.

12. The apparatus of Claim 11, wherein the sensing element is one of a hall effect sensor, an anisotropic magneto-resistive (AMR) sensor, a tunneling magneto-resistive (TMR) sensor, and a giant magneto-resistive (GMR) sensor.

13. The apparatus of Claim 11, wherein the characteristic of the magnetic field is at least one of a magnitude of the magnetic field and an angle of the magnetic field.

14. A method for assembling an apparatus, the apparatus comprising a first housing and a second housing, the first housing comprising a magnetic core having a first end and a second end and a protective case, the second housing comprising a sensing element, wherein the magnetic core is formed into a substantially complete perimeter comprising a center opening, wherein an air gap is defined between the first end and the second end of the magnetic core, the method comprising:
disposing the protective case in the air gap of the magnetic core, and
attaching the first housing to the second housing such that the protective case receives the sensing element.

15. The method of Claim 14, wherein attaching the first housing to the second housing comprises injecting an adhesive substance inside the protective case such that the adhesive substance is configured to couple the sensing element and the protective case.
